(19) Europäisches Patentamt

European Patent Office

Office européen des brevets

(11) **EP 1 693 957 A1**

## (12) EUROPEAN PATENT APPLICATION

(43) Date of publication:
**23.08.2006 Bulletin 2006/34**

(51) Int Cl.:
***H03F 3/19*** (2006.01)

(21) Application number: **06250380.0**

(22) Date of filing: **24.01.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **22.02.2005 JP 2005045637**

(71) Applicant: **Renesas
Technology Corp.
Tokyo 100-6334 (JP)**

(72) Inventors:
• **Kyu, Irei c/o Hitachi Ltd., Intellectual P. Group
Tokyo 1008220 (JP)**

• **Tanaka, Satoshi c/o Hitachi Ltd., Int. P. Group
Tokyo 1008220 (JP)**
• **Maeda, Kouji c/o Hitachi Ltd., Int. P. Group
Tokyo 1008220 (JP)**
• **Akamine, Yukinori c/o Hitachi Ltd., Int. P. Group
Tokyo 1008220 (JP)**

(74) Representative: **Calderbank, Thomas Roger et al
Mewburn Ellis LLP
York House
23 Kingsway
London WC2B 6HP (GB)**

(54) **Multi-band low noise amplifier and its input impedance matching**

(57)     A multi-band radio module for selectively supplying received signals in a plurality of frequency bands to a low noise amplifier via an input impedance matching circuit by switching over the operation mode of the low noise amplifier is comprised of : a pre-stage amplification unit including a plurality of fundamental amplifiers connected to one another in parallel, the fundamental amplifiers sharing a load impedance connected to a source voltage and a grounded degeneration impedance and having input signal lines commonly connected to an input impedance matching circuit; a post-stage amplifier to which the output signals of the plurality of fundamental amplifiers are commonly inputted; and a bias control unit for selectively turning on the fundamental amplifiers, wherein the input impedance of the low noise amplifier is selectively optimized for the matching circuit depending on the RF band to be received.

## FIG.1

**Description**

The present invention relates to a multi-band wireless communication technology which selectively uses a plurality of radio frequency (RF) bands, and more particularly to a multi-band low noise amplifier adaptable to a plurality of RF bands, and a wireless semiconductor integrated circuit (RF-IC), a multi-band low noise amplifier module and a multi-band RF module to which the amplifier is applied.

In prior art of RF-ICs for mobile phones, an RF-IC having also the function of communicating with wireless LANs and an RF-IC having also the function for Bluetooth that uses the same 2.4 GHz band as IEEE 802.11 b/g wireless LAN are known, for instance, as proposed in: Manku, et al., "A single chip direct conversion CMOS transceiver for quad-band GSM/GPRS/EDGE and WLAN with integrated VCO's and Fractional-N synthesizer," RFIC Symposium, 2004, Digest of Papers, June 6-8, 2004, pp. 923-426 (Non-Patent Document 1). In another approach in the prior art for multi-band amplifiers, a matching circuit that is comprised of a capacitor, an inductor and a microstrip line and makes possible matching of the input impedance of a bipolar transistor to 50Ω in a wide frequency band of 1 GHz to 2 GHz is known, for instance, as proposed in: Alfy Riddle and R. J. Trew, "A Broad-Band Amplifier Output Network Design," IEEE Transactions on Microwave Theory and Techniques, Vol. MTT-30, No. 2, Feb. 1982, pp. 192-196 (Non-Patent Document 2).

In a third approach in the prior art for multi-band amplifiers, Japanese Unexamined Patent Publication No. 11-251584 (Patent Document 1) proposes an RF amplifier which intends to achieve its desired frequency characteristic in a frequency band of f1 to f2 when both a first gate voltage bias circuit and a second gate voltage bias circuit are on and in a band of f3 to f4, lower than that of f1 to f2 when only the first gate voltage bias circuit is on. In a variation of this approach, Japanese Unexamined Patent Publication No. 2001-267864 (Patent Document 2) proposes an RF amplifier, which intends to achieve selective optimization in a plurality of frequency bands by selectively turning on a first or second FET element.

The globalization of wireless communication systems has introduced a requirement for wireless communication systems that have a plurality of frequency bands, such as the GSM mobile phone wireless communication system having RF bands (900 MHz band and 1.8 GHz band) to be used for the European system (referred to hereafter as GSM900 and DCS, respectively for 900 MHz band and 1.8 GHz band) and RF bands (850 MHz band and 1.9 GHz band) to be used for the U.S. system (referred to hereafter as GSM850 and PCS, respectively for 850 MHz band and 1.9 GHz band). For such a wireless communication system, in order to use the same terminal in both Europe and the U.S., a multi-band wireless terminal adaptable to a plurality of RF bands would be very convenient for terminal users.

In addition to the GSM system family described above, wireless terminals adaptable to a plurality of RF bands are desired for mobile phone systems of the CDMA 2000 system family as well. Also, if the communication speeds of mobile phones increase, a shortage of available frequencies in the existing RF bands will arise, and new RF bands may be allocated for use by mobile phones. In that case, mobile phones adaptable to both the existing RF bands and new RF bands would be desirable. In wireless LAN systems, too, a wireless modem adaptable to both the IEEE 802.11b/g specification using the 2.4 GHz band and the IEEE 802.11a specification using the 5.2 GHz band would be required. Moreover, in the case of mobile phones, there are both a trend tomount a function to communicate with wireless LANs, as is the case with the RF-IC disclosed in Non-Patent Document 1 for instance, and a trend to mount Bluetooth function that uses the same 2.4 GHz band used by IEEE 802.11b/g wireless LAN.

In order to enhance the mobility of wireless terminals, it is necessary to reduce their size, and this matter essentially requires larger-scale integration of semiconductor circuits and size reduction of peripheral circuit components. Whereas a wireless apparatus is comprised of many different components, semiconductor integrated circuit technology has made possible integration of the main functional circuit elements of the wireless apparatus. For example, an RF circuit, which includes a power amplifier (PA), a low noise amplifier (LNA), a mixer, and a local frequency synthesizer composed of a voltage controlled oscillator (VCO) and a phase lock loop (PLL), and a low frequency circuit, which includes a variable gain amplifier (VGA) and other elements, may be integrated into one chip or a few chips. A radio module is comprised of these large-scale integrated circuit (LSI) chips and other unintegrated discrete circuit elements mounted in high density on a printed circuit board.

In pursuit of even smaller size, a latest wireless apparatus may feature a zero intermediate frequency (ZIF) architecture, which is also known as direct conversion architecture, or a low intermediate frequency (LIF) architecture, both of which have a smaller number of filters than previous architectures and integrate channel select filters (CSFs) into a single chip together with RF and low frequency circuits. Since ZIF is frequently used in mobile phones, ZIF architecture will be presupposed in the discussion of problems with the prior art and the description of preferred embodiments of the present invention in this specification.

In the case where a multi-band receiver circuit for GSM use adaptable to a plurality of different RF bands is to be integrated, a frequency converter and subsequent circuits in a receiver circuit for directly converting RF signals into frequencies of 1 MHz or below can be configured for common use by a plurality of bands with relative ease.

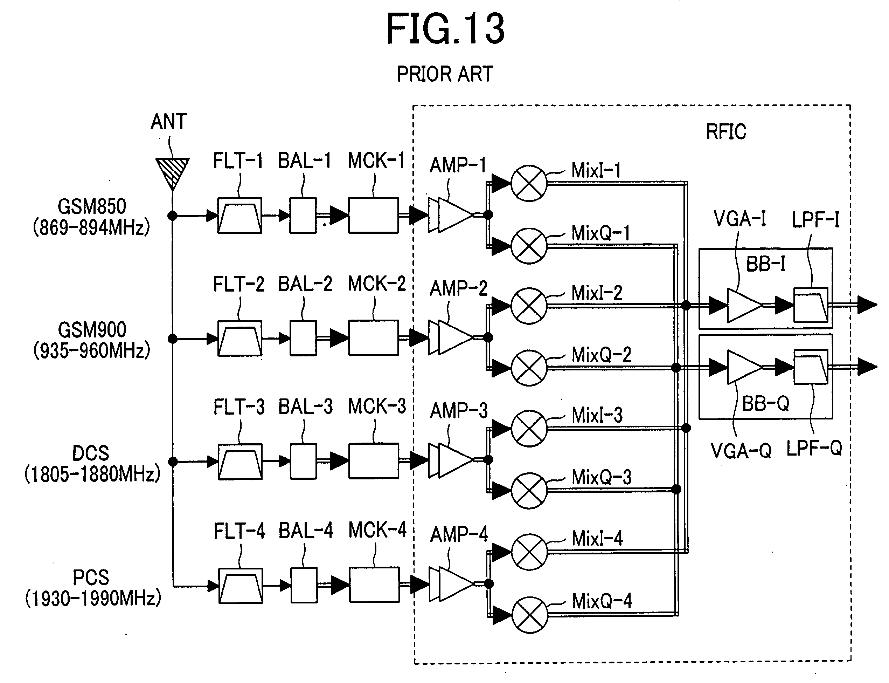

FIG. 13 shows, as one example of receiver circuit of a typical QUAD band RF module, the main parts of a multi-band receiver circuit adaptable to GSM850, GSM900, DCS and PCS.

Radio signals from a base station of the GSM850 system are received by an antenna ANT and entered into a band pass filter FLT-1 via an antenna switch (not shown). Interference signals and noise outside the GSM850 band are suppressed by this band pass filter FLT-1. Signals on all the channels in the reception frequency band of GSM850 selected by the band pass filter FLT-1 are converted by a balun BAL-1 from single-end signals into differential signals. The output signals of BAL-1 are entered into a low noise amplifier AMP-1 of the GSM850 band via an input impedance matching circuit MCK-1.

The signals amplified by the low noise amplifier AMP-1 are equally divided and entered into I/Q mixers MixI-1 and MixQ-1 and converted into baseband I/Q signals. A local frequency synthesizer for frequency conversion is not shown in the drawing here to simplify illustration. The outputs (wanted signals) of the I/Qmixers MixI-1 andMixQ-1 are entered into an I signal baseband circuit BB-I comprised of a low pass filter LPF-I and a variable gain amplifier VGA-I and a Q signal baseband circuit BB-Q comprised of a low pass filter LPF-Q and a variable gain amplifier VGA-Q, respectively, thereby amplifying these wanted signals to desired intensities. The outputs of the low pass filters LPF-I and LPF-Q are demodulated by circuit portions (not shown), configured on another chip, subsequent to the RF-IC.

In the baseband circuits BB-I and BB-Q, the low pass filters LPF-I and LPF-Q may have multi-stage circuit configurations depending on the required level of filter performance. The variable gain amplifiers VGA-IQ and VGA-Q also may have multi-stage circuit configurations depending on the required dynamic range of signal amplification. Although variable gain filters can be incorporated into the low pass filter, their discussion will be dispensed with here because they have no direct bearings on the present invention.

Radio signals transmitted from a base station of the GSM900 system are entered into the baseband circuits BB-I and BB-Q by way of the antenna ANT, the antenna switch (not shown), a band pass filter FLT-2, a balun BAL-2, an input impedance matching circuit MCK-2, a GSM900 band low noise amplifier AMP-2, and mixers MixI-2 and MixQ-2.

DCS radio signals transmitted from a base station of the DCS system are entered into the baseband circuits BB-I and BB-Q by way of the antenna ANT, the antenna switch (not shown), a band pass filter FLT-3, a balun BAL-3, an input impedance matching circuit MCK-3, a DCS band low noise amplifier AMP-3, and mixers MixI-3 and MixQ-3.

PCS radio signals transmitted from a base station of the PCS system are entered into the baseband circuits BB-I and BB-Q by way of the antenna ANT, the antenna switch (not shown), a band pass filter FLT-4, a balun BAL-4, an input impedance matching circuit MCK-4, a PCS band low noise amplifier AMP-4, and mixers MixI-4 and MixQ-4.

Since this RF module never performs reception processing of the aforementioned four kinds of radio signals at the same time, the functions of other RF circuits have to be suspended except the RF circuit corresponding to the wireless communication band from which signal reception is desired. The control circuitry for selectively actuating only the desired receiver circuit will not be described here because it is well known to persons skilled in the art.

Next, a prior art impedance matching circuit technology adaptable to a plurality of RF bands will be described.

FIG. 14 shows a matching circuit described in Non-Patent Document 2. This matching circuit, comprising capacitors C11 and C12, inductors L11 and L12, and microstrip lines MSL11 and MSL12, matches the input impedance of a bipolar transistor Tr11 to 50Ω in a frequency band of 1 GHz to 2 GHz. However, a circuit configuration requiring microstrip lines on a mounting substrate lacks attractiveness for general module manufacturers not well versed in specialized technology of this kind. Moreover, a circuit configuration requiring many components for its matching unit would invite a low product yield.

FIG. 15 shows an RF amplifier disclosed in Patent Document 1. In this RF amplifier, the first gate terminal 26a of a FET 25 is connected to a first gate voltage bias circuit 27a, the second gate terminal 26b of the same is connected to a second gate voltage bias circuit 27b and an input matching circuit 28, and the drain terminal 30 of the same is connected to a drain voltage terminal 31 and an output matching circuit 32, the source terminal 34 of the same is grounded and a resistor 43 is connected between the first gate terminal 26a and the second gate terminal 26b.

This RF amplifier is intended to achieve the desired frequency characteristic in the f1 to f2 band when both the first gate voltage bias circuit 27a and the second gate voltage bias circuit 27b are turned on and the desired frequency characteristic in the f3 to f4 band, lower than the f1 to f2 band when only the second gate voltage bias circuit 27b is turned on. However, since the gate capacitance of an FET usually becomes greater when it is in on state than when it is in off state, it is not easy to achieve the expected characteristic with the above-described circuit configuration, and many problems have to be solved to make it useful for practical purposes.

FIG. 16 shows an RF amplifier disclosed in Patent Document 2. This RF amplifier has an amplification unit 30 comprising a first FET element 301, a second FET element 302, an input matching circuit 10 connected between the amplification unit 30 and an input terminal 1, and an output matching circuit 20 connected between the amplification unit 30 and an output terminal 2. Although Patent Document 2 states that a plurality of frequency bands can be selectively optimized by selectively turning on the first and second FET elements, there is no mention of specific design values for the first and second FETs or about the relationship between the configuration of the input/output matching circuits and frequency bands. Therefore it has a problem of total vagueness of the specific way in which the plurality of frequency bands can be selectively optimized.

Generally, an RF circuit can satisfy the performance requirement only in a narrow frequency band. The reason lies in the problem of impedance matching. Unless the signal source impedance and the input impedance of the signal receiver circuit are matched with each other, a part of the signal power will be reflected. The conditions of impedance matching can be expressed in the following equations:

$$Zs = Zin \qquad\qquad (1)$$

$$Xs + Xin = 0 \qquad\qquad (2)$$

In these equations, Zs and Xs respectively represent the real part and the imaginary part of the signal source impedance, and Zin and Xin, those of the input impedance of the signal receiver circuit. Xs and Xin are inverse in sign to each other. Basically, the absolute value of the positive imaginary impedance varies in proportion to the frequency while that of the negative imaginary impedance varies in reverse proportion to the frequency. Therefore, there exists theoretically only one frequency that enables Equation (2) to be satisfied.

When low Q elements are used, reflection due to impedance mismatching can be reduced over a relatively wide frequency range because a deviation in frequency would not cause a quick deterioration in impedance matching. At the same time, however, there would be a problem of increased power loss. On the other hand, if high Q elements are used to reduce power loss, impedance matching will quickly deteriorate when the frequency deviates from an optimum value because the frequency range of low reflection is limited to the vicinities of that specific frequency.

A high Q means that impedance matching is sensitive to the parasitic inductances or the parasitic capacitances of circuit elements. However, since manufactured and marketed external elements are generally restricted to specific kinds having discrete values of inductances or capacitances, it is difficult in practice to configure a matching circuit having ideal characteristics by using commercially available circuit elements. Therefore, it is far from easy to make a single matching circuit, comprised of external elements, adapted to a plurality of RF bands required by a multi-band receiver circuit.

For these reasons, shared use of a low noise amplifier (LNA) circuit is given up for conventional QUAD band RF-ICs, and instead a low noise amplifier LNA is usually provided for each RF band (AMP-i, i=1 to 4) as shown in FIG. 13. Moreover, as shared use of a mixer would entail longer wiring between the LNA and the mixer and accordingly increased loss, a mixer is usually provided for each AMP-i to reduce wiring loss as shown in FIG. 13.

Since external elements occupy a predominant part of the module area in a conventional multi-band wireless terminal in which an RF circuit comprising an LNA and a mixer is provided for each RF band as described above, it is difficult to reduce the size and cost of hardware and adapt it to new RF bands. Furthermore, additional integration of RF circuits for new bands, keeping this architecture, makes it increasingly difficult to achieve a satisfactory yield on account of the limitation of LSI manufacturing technology.

An aim of the present invention, in view of the above-mentioned circumstances and practical difficulties, is to provide a multi-band low noise amplifier adaptable to a plurality of RF bands.

Another aim of the invention is to provide a wireless semiconductor integrated circuit reduced in chip size and a multi-band radio module reduced in the number of external circuit elements required.

Still another aim of the invention is to provide a receiver circuit technology required for variable RF band wireless apparatuses to meet requirements for high speed and wide band wire less communication systems foreseen for the near future.

According to the invention, received signals in a plurality of frequency bands are preferably selectable by a front end circuit are selectively supplied to a low noise amplifier by using the same input impedance matching circuit, and the input impedance of the low noise amplifier is optimized depending on the RF band to be received.

Thus, amulti-band low noise amplifier according to the invention comprises: a pre-stage amplification unit including a plurality of fundamental amplifiers connected to one another in parallel, the fundamental amplifiers sharing a load impedance connected to a source voltage and sharing a grounded degeneration impedance and having signal lines commonly connected to an input impedance matching circuit; and a post-stage amplifier to which the output signals of the plurality of fundamental amplifiers are commonly inputted, wherein the input impedance of the pre-stage amplification unit is selectively optimized for a plurality of RF bands according to the ways for supplying bias voltages to the plurality of fundamental amplifiers.

In further detail, the multi-band low noise amplifier according to the invention may comprise a pre-stage amplification unit including first and second fundamental amplifiers connected to one another in parallel, the fundamental amplifiers sharing a load impedance connected to a source voltage and sharing a grounded degeneration impedance and having input signal lines commonly connected to an input impedance matching circuit; a post-stage amplifier to which the output signals of the first and second fundamental amplifiers are commonly inputted; and a pre-stage bias control unit for supplying a bias voltage to the first fundamental amplifier through a first bias resistor and to the second fundamental amplifier through a serial circuit of a control switch and a second bias resistor, wherein the input impedance of the pre-stage amplification unit is optimized for a first RF band by the first fundamental amplifier and degeneration impedance when the control switch is off, and optimized for a second RF band lower in frequency than the first RF band by the first and second fundamental amplifiers and degeneration impedance when the control switch is on. This configuration makes it possible to realize a dual type RF module capable of selectively receiving signals in two RF bands by using a combination of an input impedance matching circuit and a low noise amplifier.

In another aspect of the invention, a multi-band low noise amplifier comprise a pre-stage amplification unit including N (N is an integer of more than 2) fundamental amplifiers connected to one another in parallel, the fundamental amplifiers sharing a load impedance connected to a source voltage and a grounded degeneration impedance and having input signal lines commonly connected to an input impedance matching circuit; a post-stage amplifier to which the output signals of the N fundamental amplifiers are commonly inputted; and a pre-stage bias control unit for supplying a bias voltage to each of the fundamental amplifiers of the pre-stage amplification unit through an individual bias resistor, wherein the pre-stage bias control unit includes (N-1) control switches each connected in series to each of the bias resistors so that a bias voltage is constantly supplied to the first fundamental amplifier and selectively to each of the second through N-th fundamental amplifiers, and the input impedance of the pre-stage amplification unit is optimized for a first RF band by the first fundamental amplifier and the degeneration impedance when all of the control switches are off, and optimized for another RF band lower than the first RF band by the first fundamental amplifier, the degeneration impedance, and at least one of the other fundamental amplifiers that is made operational by the supply of a bias voltage when the control switches corresponding to the fundamental amplifiers made operational are on. This configuration makes it possible to realize a multi-band RF module capable of selectively receiving signals in three or more RF bands by using a combination of an input impedance matching circuit and a low noise amplifier.

According to the invention, a differential multi-band low noise amplifier which outputs differentially amplified signals relative to differential input signals can be configured by applying the multi-band low noise amplifier described above to a first low noise amplifier connected to a first input impedance matching circuit for positive input signals, and a second low noise amplifier connected to a second input impedance matching circuit for negative input signals. In this case, the pre-stage bias control units of the first and second low noise amplifiers may share a control switch connected to their corresponding bias resistors.

According to the invention, variations of the input impedance of the low noise amplifier can be kept within a permissible range so that the low noise amplifier and the input impedance matching circuit can be matched with each other even when the RF band has been switched over to another band. In one embodiment of the invention, each of the fundamental amplifiers of the pre-stage amplification unit and the post-stage amplifier is comprised of a field effect transistor, and inductor elements are used as degeneration impedances. In this case, by designing the gate width of each field effect transistor constituting the fundamental amplifier of the pre-stage amplification unit so that the input equivalent capacitance of the plurality of field effect transistors operating in parallel match the receive RF band, the input impedance can be kept effectively constant in every RF band.

A wireless semiconductor integrated circuit according to the invention comprises a low noise amplifier, an I signal mixer and a Q signal mixer for converting the output signals of the low noise amplifier into baseband I and Q signals, an I signal baseband circuit connected to the I signal mixer, and a Q signal baseband circuit connected to the Q signal mixer, such that the low noise amplifier comprises of a pre-stage amplification unit including a plurality of fundamental amplifiers connected in parallel to each other, a post-stage amplifier, and a pre-stage bias control unit, wherein the input impedance of the low noise amplifier is matched with a plurality of different RF bands by turning the control switch on or off.

A multi-band RF module according to the invention comprises a front end circuit for switching among a plurality of RF bands to be received, and a RF semiconductor integrated circuit for converting received signals of the RF band selected by the front end circuit into baseband signals, such that the front end circuit includes a plurality of band pass filters each for selecting a frequency band to be, received, a plurality of balun circuits, each fabricated for a different band, for converting single-end signals into differential signals, a band selector switch connected between the band pass filters and balun circuits, and an input impedance matching circuit connected to the plurality of balun circuits. The RF semiconductor integrated circuit includes a multi-band low noise amplifier for receiving through an input impedance matching circuit multi-band signals selectable by the front end circuit. It is also conceivable to use a variable bandpass filter instead of the plurality of band pass filters, so that the single variable band pass filter selectively receives a plurality of different RF bands.

According to the invention, since a plurality of RF bands can share a low noise amplifier, the wireless semiconductor integrated circuit can be reduced in size.

In the drawings:

FIG. 1 shows a first embodiment of a multi-band low noise amplifier LNA according to the invention.

FIG. 2 shows a second embodiment of a multi-band low noise amplifier LNA according to the invention.

FIG. 3A and FIG. 3B show low-band frequency characteristics obtained by simulation for a single-band LNA and a dual-band LNA according to the invention, respectively.

FIG. 4A and FIG. 4B show high-band frequency characteristics obtained by simulation for the single-band LNA and the dual-band LNA according to the invention, respectively.

FIG. 5 shows a third embodiment of a multi-band low noise amplifier LNA according to the invention.

FIG. 6 shows a fourth embodiment of a multi-band low noise amplifier LNA according to the invention.

FIG. 7 shows a fifth embodiment of a multi-band low noise amplifier LNA according to the invention.

FIG. 8 shows a sixth embodiment of a multi-band low noise amplifier LNA according to the invention.

FIG. 9 shows an embodiment of a QUAD band radio module, to which a multi-band low noise amplifier LNA according to the invention is applied.

FIG. 10 shows another embodiment of a QUAD band radio module, to which a multi-band low noise amplifier LNA according to the invention is applied.

FIG. 11 shows still another embodiment of a QUAD band radio module, to which a multi-band low noise amplifier LNA according to the invention is applied.

FIG. 12 shows yet another embodiment of a QUAD band radio module, to which a multi-band low noise amplifier LNA according to the invention is applied.

FIG. 13 shows one example of QUAD band radio module according to the prior art.

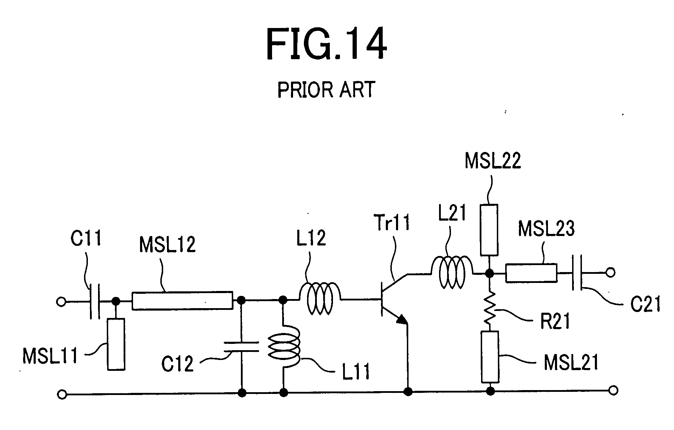

FIG. 14 shows one example of multi-band RF amplifier according to the prior art.

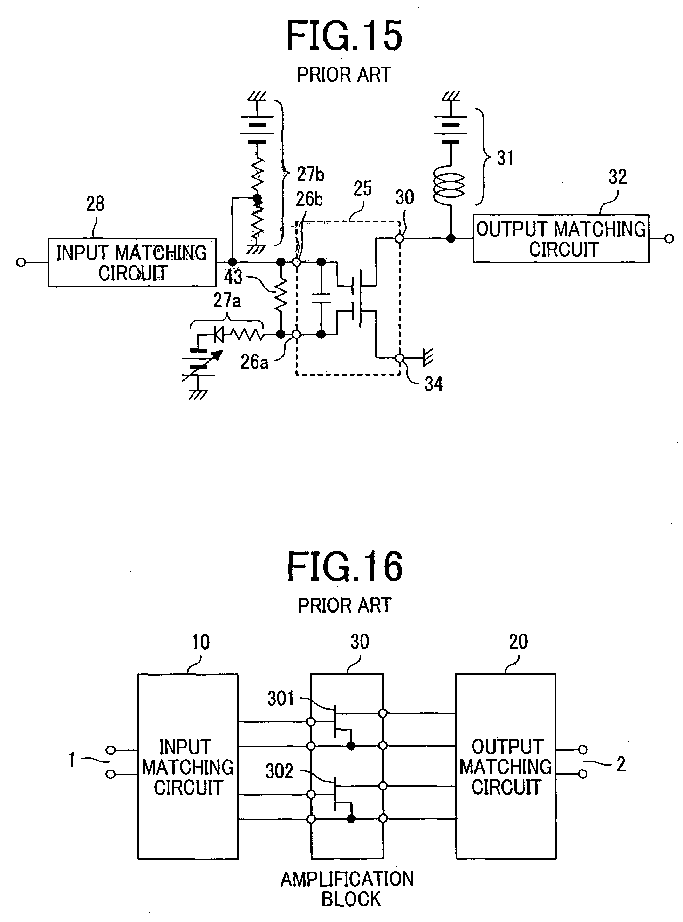

FIG. 15 shows another example of multi-band RF amplifier according to the prior art.

FIG. 16 shows still another example of multi-band RF amplifier according to the prior art.

Some embodiments of multi-band LNAs according to the present invention will be described below with reference to accompanying drawings.

[First Embodiment]

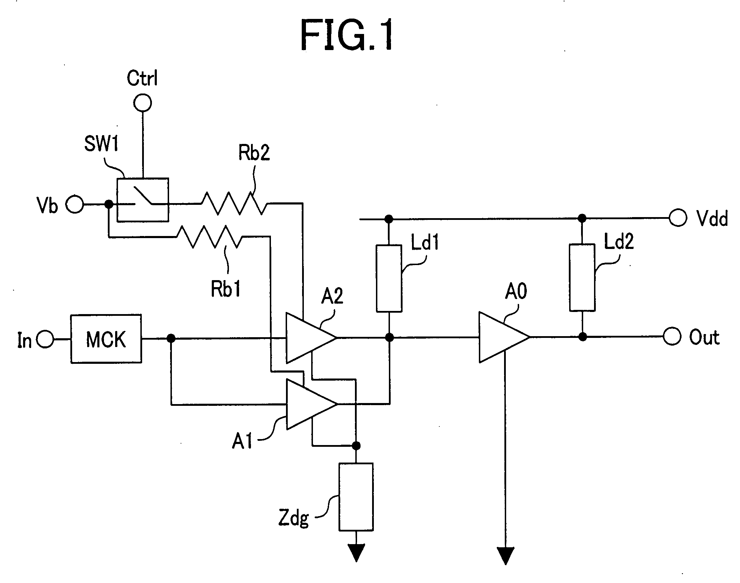

FIG. 1 shows a multi-band low noise amplifier LNA adaptable to two RF bands including a high-band HB and a low-band LB, as a first embodiment of the invention.

Only the main part of the LNA is shown here to simplify illustration. Illustration of the antenna ANT, the antenna switch and the band pass filters FLT arranged on the input side of the LNA and the mixers MixI and MixQ, the local frequency synthesizer, the baseband circuit, and the control circuit for frequency band selection arranged on the input side of the LNA is dispensed with.

The LNA of this embodiment has a pre-stage amplification unit comprising first and second fundamental amplifiers A1 and A2 connected in parallel to each other. These fundamental amplifiers share a load impedance Ld1 connected to a source voltage Vdd, a grounded degeneration impedance Zdg and an input impedance matching circuit MCK. A bias voltage Vb for turning on the fundamental amplifiers A1 and A2 is supplied to the first fundamental amplifier A1 through a first bias resistor Rb1 and to the second fundamental amplifier A2 through a serial circuit of a control switch SW1 and a second bias resistor Rb2. The control switch SW1 is opened and closed with a control signal inputted to a terminal Ctrl.

The output signals of the band pass filters FLT are supplied as input signals to the fundamental amplifiers A1 and A2 from an input signal line In through the input matching circuit MCK. The output signals of the fundamental amplifiers A1 and A2 are provided as a common input to a fundamental amplifier A0 of a post-stage amplification unit having a load impedance Ld2 connected to the source voltage Vdd, and the output signal of the fundamental amplifier A0 is derived from an output signal line Out as the output signal of the multi-band LNA. A bias voltage for operating the fundamental amplifier A0 is not shown here for the sake of simplification of illustration.

When this multi-band LNA is desired to operate in the HB mode, a control signal for opening the control switch SW1 is given to the switching control terminal Ctrl to turn of f the second fundamental amplifier A2. Then an effective input impedance determined by the first fundamental amplifier A1 and the degeneration impedance Zdg matches the input impedance matching circuit MCK, and the multi-band LNA will have the desired HB characteristics. When the multi-band LNA is desired to operate in the LB mode, a control signal for closing SW1 is given to the switching control terminal Ctrl to turn on the second fundamental amplifierA2. Then, an effective input impedance determined by the first and second fundamental amplifiers A1 and A2 in the operating state and the degeneration impedance Zdg matches the input impedance matching circuit MCK, and the multi-band LNA will have the desired LB characteristics.

[Second Embodiment]

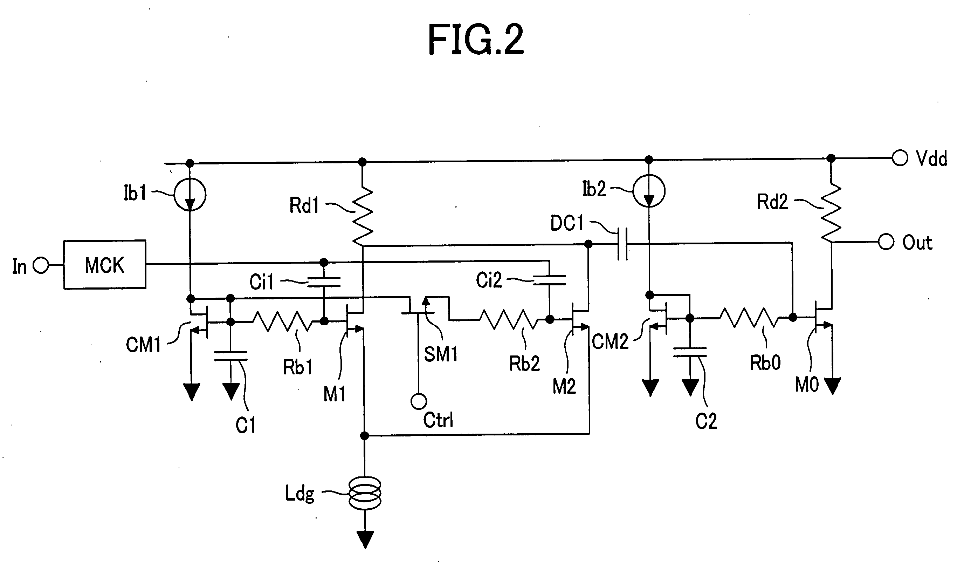

FIG. 2 shows the main part of a multi-band low noise amplifier LNA adaptable to two RF bands including a high-band HB and a low-band LB, as a second embodiment of the invention. As in the first embodiment, the circuit elements connected to the input and output sides of the multi-band LNA are not shown here for the sake of simplification of illustration.

The multi-band LNA of this embodiment has a pre-stage amplification unit comprising first and second field effect transistors M1 and M2 connected in parallel, and these field effect transistors share a load resistor Rd1 connected to the source voltage Vdd, a grounded degeneration inductance Ldg and the input impedance matching circuit MCK. Capacitor elements Ci1 and Ci2 for separating DC potentials are inserted between MCK and the first and second field effect transistors M1 and M2.

A bias voltage Vb for turning on the first and second field effect transistors M1 and M2 is supplied from a first current mirror circuit comprised of a field effect transistor CM1. The level of the output bias voltage Vb is controlled by a reference current source Ib1 connected between the field effect transistor CM1 and the source voltage Vdd. The reference current source Ib1 is a circuit for generating a current determined by the reference voltage generated by a reference voltage generating circuit, and its specific circuit configuration will not be described in detail here because it is well known to persons skilled in the art.

Reference symbol C1 denotes a shunt capacitance for short-circuiting the gate of the field effect transistor CM1 toward the ground side for high frequency isolation of the RF circuit and the bias circuit. The bias voltage Vb supplied from the current mirror circuit is supplied to the first field effect transistor M1 through the first bias resistor Rb1 and to the second field effect transistor M2 through a serial circuit of a control switch SM1, which is comprised of a field effect transistor, and the second bias resistor Rb2. The control switch SM1 is opened and closed with a control signal inputted to a terminal Ctrl.

The outputs of the first and second field effect transistors M1 and M2 are commonly entered into a field effect transistor M0 of a post-stage amplification unit having a load resistor Rd2 connected to the source voltage Vdd. The output signal of the field effect transistor M0 is derived from the output signal line Out as the output signal of the multi-band LNA. A bias voltage for turning on the field effect transistor M0 is supplied from a second current mirror circuit configured of a field effect transistor CM2 through a bias resistor Rb0. Reference symbol Ib2 denotes a reference current source connected to the second current mirror circuit and C2 denotes a shunt capacitance.

When this multi-band LNA is desired to operate in the HB mode, a control signal for opening the control switch SW1 is given to the terminal Ctrl to turn off the second field effect transistor M2. Then an effective input impedance determined by the input capacitance of the first field effect transistor M1 and the degeneration inductance Ldg matches the matching circuit MCK, and the multi-band LNA will have the desired HB characteristics.

When the multi-band LNA is desired to operate in the LB mode, a control signal for closing the control switch SW1 is given to the switching control terminal Ctrl to turn on the second field effect transistor M2. Then, an effective input impedance determined by the equivalent input capacitance of the first and second field effect transistors M1 and M2 and the degeneration impedance Ldg matches the input impedance matching circuit MCK, and the multi-band LNA will have the desired LB characteristics.

Next, the conditions of multi-band impedance matching in a circuit with the impedance matching circuit MCK will be described.

Generally speaking, the input impedance of a field effect transistor can be regarded equivalently as a serial circuit of a small low input resistor and a small input capacitor. If the capacitance of the input capacitor is small, a high inductance will be needed to set it off. However, in order to obtain a high inductance with a chip inductance formed over a semiconductor substrate, the values of the parasitic resistance and the parasitic capacitance of the chip inductance will pose a problem. The higher the inductance, the greater the values of these parasitic elements. Therefore, it is not easy to achieve desired matching circuit characteristics with a chip inductance.

According to the circuit configuration shown in FIG. 2, however, as a large current Ids flows in the degeneration inductor Ldg connected between the sources of the field effect transistors M1 and M2 and the ground, a large inductance effect is obtained even if the actual inductance of Ldg is relatively low. Taking note of this phenomenon, the present invention tunes the equivalent resistance in the input impedance of the multi-band LNA to about 50Ω by utilizing the high inductance effect produced by the relatively small inductor Ldg connected to the first and second field effect transistors M1 and M2 and optimization of the gate widths of these field effect transistors. In this case, the matching circuit MCK can adapt to the switching-over of the frequency band (HB, LB) with a simple configuration comprising only serial inductors connected to the gates of the field effect transistors M1 and M2.

To explain further let us suppose, for instance, the characteristics of the first field effect transistor M1 and of the degeneration inductor Ldg are optimized, matched with the characteristics of the high-band (HB). In this case, the following considerably simplified relation holds approximately between the frequency and the parameter values of elements:

$$2\pi f_H * L_{dg} - 1/(2\pi f_H * C(M1, Vb_H)) = 0$$

In this equation, $f_H$ is the center frequency of HB, $L_{dg}$, the inductance of the degeneration inductor Ldg, and C (M1, $Vb_H$), the equivalent input capacitance of the first field effect transistor M1 at the bias voltage for HB, $Vb_H$.

When the multi-band LNA is switched over to the low band LB, the drop in signal frequency results in a decrease in the inductance effect of the degeneration inductor Ldg. However, according to the circuit configuration of this second embodiment, the second field effect transistor M2 is connected in parallel to the first field effect transistor M1 in the LB mode. In this case, as the equivalent input capacitance increases to compensate for the decrease in the inductance effect due to the signal frequency drop, the input impedance can be optimized in LB.

To simplify description, it is supposed, for instance, that the HB frequency to be received is double the frequency of LB. In this case, if the gate width of the second field effect transistor M2 is designed to be three times that of the first field effect transistor M1, the input equivalent capacitances of the two transistors M1 andM2 in operation, connected to each other in parallel, will be quadrupled, and therefore an inductance effect equal to that in the HB mode can be obtained in the LB mode according to the following equation:

$$2\pi f_L * L_{dg} - 1/(2\pi f_L * C(M1+M2, Vb_L)) = 0$$

In a practical application, the input equivalent capacitances in the LB mode cannot be made accurately proportional to the combined gate width of the first and second field effect transistors M1 and M2 for such reasons as the input equivalent capacitance of M2 is not reduced to zero and other parasitic effects are at work even when the second field effect transistor M2 is turned off in the HB mode. Yet, by determining in advance the gate widths of M1 and M2 according to the frequencies of HB and LB and finely adjusting the gate width of M2, the input equivalent capacitance in the LB mode can be substantially optimized (kept within the permissible range).

In order to enable the above-stated conditions to hold, it is necessary to keep the current Ids (M1) flowing to the first field effect transistor M1 in the HB mode and the current Ids (M1 + M2) flowing to M1 and M2 in the LB mode at their respective optima by adjusting the reference current source Ib1. The design values for adjusting the reference current source Ib1 in this way can be figured by calculation or simulation.

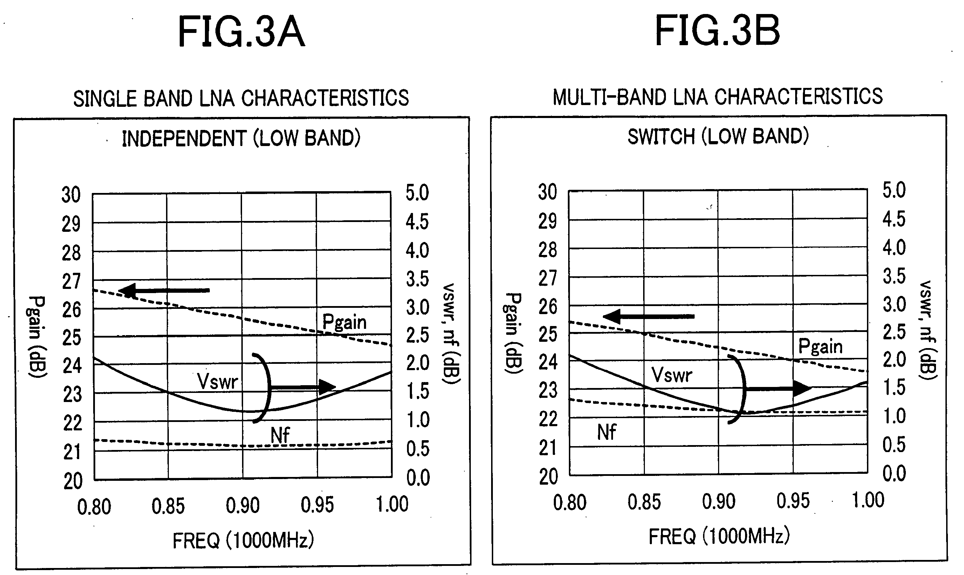

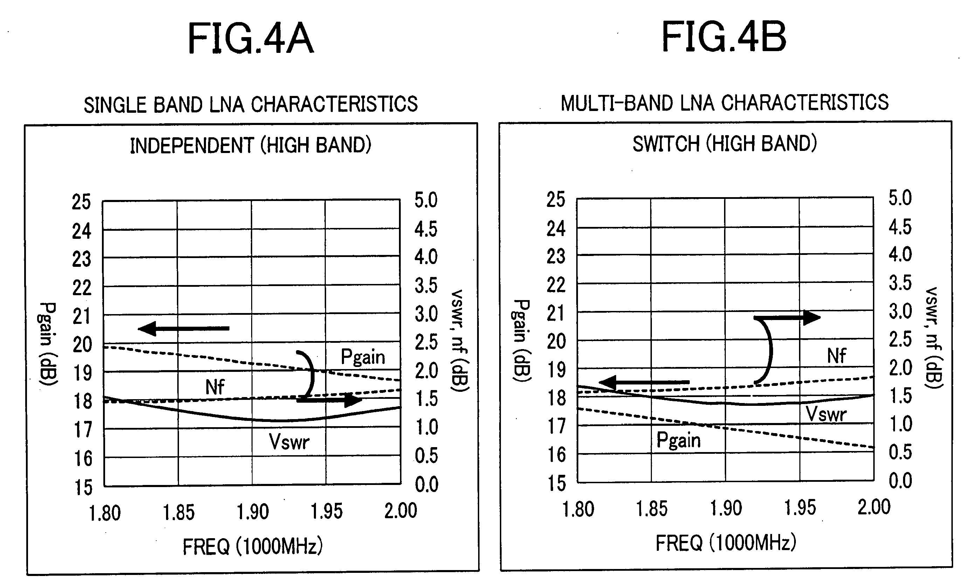

FIGS. 3A, 3B, 4A and 4B show the results of simulation obtained under the same drain current conditions respectively for a multi-band LNA and a single-band LNA designed by adopting the above-described input impedance matching method. FIGS. 3A and 3B respectively show the characteristics of the single-band LNA and those of the multi-band LNA in the low band (LB). FIGS. 4A and 4B respectively show the characteristics of the single-band LNA and those of the multi-band LNA in the high band (HB).

In each graph, the horizontal axis represents the frequency. Several LNA characteristics are shown. Pgain represents the gain, Nf, the noise factor and Vswr, the reflection coefficient indicating the input match closeness. It is seen from these simulation results that the characteristics of the multi-band LNA of this embodiment would pose little trouble in practical use though slightly inferior in performance to the single-band LNA, while providing a great advantage in terms of the size reduction of hardware.

[Third Embodiment]

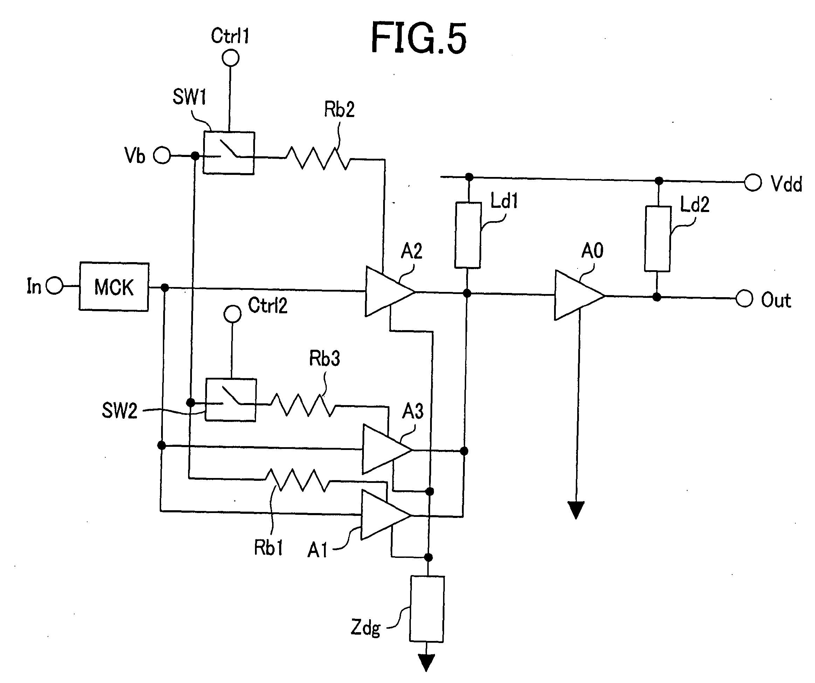

FIG. 5 shows the main part of a multi-band LNA adaptable to three RF bands including a high band (HB), a mid-band (MB) and a low-band (LB) as a third embodiment of the invention. As was the case with the first embodiment, the circuit elements connected to the input and output sides of the multi-band LNA are not shown here for the sake of simplification of illustration.

In the multi-band LNA of this embodiment, a third fundamental amplifier A3 is further connected in parallel to the first and second fundamental amplifiers A1 and A2 constituting the pre-stage amplification unit of the first embodiment (FIG. 1). These three fundamental amplifiers share the load impedance Ld1 connected to the source voltage Vdd, the grounded degeneration impedance Zdg and the input impedance matching circuit MCK.

The bias voltage Vb for turning on the fundamental amplifiers is supplied all the time to the first fundamental amplifier A1 through the first bias resistor Rb1, selectively to the second fundamental amplifier A2 through the serial circuit of the control switch SW1 and the second bias resistor Rb2 and to the third fundamental amplifier A3 through the serial circuit of a control switch SW2 and a third bias resistor Rb3. The control switches SW1 and SW2 are opened and closed with control signals supplied to their respective terminals Ctrl1 and Ctrl2. The outputs of the fundamental amplifiers A1, A2 and A3 are commonly entered into the fundamental amplifier A0 of a post-stage amplification unit having the load impedance Ld2 connected to the source voltage Vdd. The output signal of the fundamental amplifier A0 serves as the output of the multi-band LNA. The bias voltage for turning on the fundamental amplifier A0 of the post-stage amplification unit is not shown here for the sake of simplification of illustration.

When the multi-band LNA is desired to operate in the HB mode, the second and third fundamental amplifiers A2 and A3 are turned off by supplying a control signal for opening the control switch SW1 to the terminal Ctrl1 and a control signal for opening the control switch SW2 to the terminal Ctrl 2. Then the effective input impedance of the first fundamental amplifier A1 matches the matching circuit MCK, and the multi-band LNA will have the desired HB characteristics.

When the multi-band LNA is desired to operate in the MB mode, the second fundamental amplifier A2 is turned on by supplying a control signal for closing the control switch SW1 to the terminal Ctrl1, and the third fundamental amplifier A3 is turned off by supplying a control signal for opening the control switch SW2 to the terminal Ctrl2. Then the combined equivalent input impedances of the first and second fundamental amplifiers A1 and A2 connected in parallel match the matching circuit MCK, and the multi-band LNA will have the desired MB characteristics.

When the multi-band LNA is desired to operate in the LB mode, the second and third fundamental amplifiers A2 and A3 are turned on, by supplying control signals for closing the control switches SW1 and SW2 to the terminal Ctrl1 and Ctrl2, respectively. Then the combined equivalent impedances of the first; second and third fundamental amplifiers A1, A2 and A3 connected in parallel match the matching circuit MCK, and the multi-band LNA will have the desired LB characteristics.

In the case where the available choice of RF bands consist of four or more bands, fourth, fifth and anymore required fundamental amplifiers can be added to the pre-stage amplification unit, and connected to the load impedance Ld1, the degeneration impedance Zdg and the input impedance matching circuit MCK in the same manner as in the connection of the third fundamental amplifier.

[Fourth Embodiment]

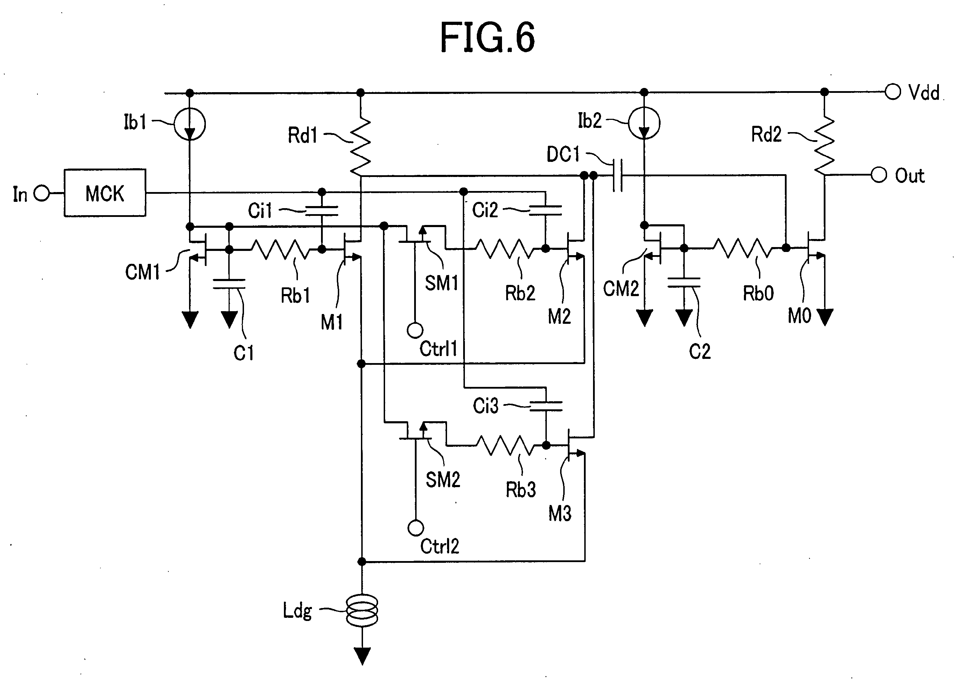

FIG. 6 shows the main part of a multi-band LNA adaptable to three RF bands including a high band (HB), a mid-band (MB) and a low-band (LB) as a fourth embodiment of the invention. As was the case with the first embodiment, the circuit elements connected to the input and output sides of the multi-band LNA are not shown here for the sake of simplification of illustration.

In the multi-band LNA of this embodiment, a third field effect transistor M3 is further connected in parallel to the first and second field effect transistors M1 and M2 in the second embodiment (FIG. 2). These three field effect transistors share the load resistor Rd1 connected to the source voltage Vdd, the grounded degeneration inductance Ldg and the input impedance matching circuit MCK. Capacitance elements Ci1, Ci2 and Ci3 for separating DC potentials are inserted between MCK and the field effect transistors M1, M2 and M3. A bias voltage Vb for tuning on the field effect transistors M1, M2 and M3 is supplied from a current mirror circuit comprised of a field effect transistor CM1. Detailed description of the current mirror circuit will be dispensed with here.

The bias voltage Vb is supplied to the first field effect transistor M1 through the first bias resistor Rb1, to the second field effect transistor M2 through a serial circuit of the control switch SM1 comprised of a field effect transistor and the second bias resistor Rb2, and to the third field effect transistor M3 through a serial circuit of the control switch SM2 comprised of a field effect transistor and the third bias resistor Rb3. The control switches SM1 and SM2 are opened and closed with control signals supplied to the terminals Ctrl1 and Ctrl2, respectively.

The outputs of the first, second and third field effect transistors M1, M2 and M3 are commonly entered into the field effect transistor M0 of a post-stage amplification unit having the load resistor Rd2 connected to the source voltage Vdd. The output of the field effect transistor M0 serves as the output signal of the multi-band LNA. A bias voltage for turning on the field effect transistor M0 is supplied from a current mirror circuit comprised of a field effect transistor CM2 through a bias resistor Rb0.

When the multi-band LNA is desired to operate in the HB mode, the second and third field effect transistors M2 and M3 are turned off by supplying control signals for opening the control switches SM1 and SM2 to the terminal Ctrl1 and the terminal Ctrl2. Then the effective input impedance of the first field effect transistor M1 matches the matching circuit MCK, and the multi-band LNA will have the desired HB characteristics.

When the multi-band LNA is desired to operate in the MB mode, the second field effect transistor M2 is turned on by supplying a control signal for closing the control switch SM1 to the terminal Ctrl1. The third field effect transistor M3 is kept off. Then the combined equivalent input impedances of the first and second field effect transistors M1 andM2 connected in parallel match the matching circuit MCK, and the multi-band LNA will have the desired MB characteristics.

When the multi-band LNA is desired to operate in the LB mode, the second and third field effect transistors M2 and M3 are turned on by supplying control signals for closing the control switches SM1 and SM2 to the terminal Ctr11 and the terminal Ctrl2. Then the combined equivalent input impedances of the first, second, third field effect transistors M1, M2 and M3 connected in parallel match the matching circuit MCK, and the multi-band LNA will have the desired LB characteristics.

To explain further let us suppose, for instance, the characteristics of the first field effect transistor M1 and of the degeneration inductor Ldg are optimized, matched with the characteristics of HB, the following approximate conditions will hold as in the case of the second embodiment, where $f_H$, $f_M$ and $f_L$ respectively denote the center frequencies of the high band (HB), the mid-band (MB) and the low-band (LB), and $Vb_H$, $Vb_M$ and $Vb_L$, the values of the gate bias voltage Vb in the respective bands mentioned above:

$$2\pi f_H * L_{dg} - 1/(2\pi f_H * C(M1, Vb_H)) = 0$$

$$2\pi f_M * L_{dg} - 1/(2\pi f_M * C(M1+M2, Vb_M)) = 0$$

$$2\pi f_L * L_{dg} - 1/(2\pi f_L * C(M1+M2+M3, Vb_L)) = 0$$

In an actual circuit, when a switch-over to the MB or LB mode has taken place, the input equivalent capacitances cannot be made accurately proportional to the combined gate widths of the pluralities of field effect transistors connected in parallel for such reasons as the input equivalent capacitances of these transistors are not reduced to zero and other parasitic effects are at work even when the second and third field effect transistors M2 and M3 are turned off. Moreover, as the gate bias voltage Vb may also vary, it is difficult to make the input equivalent capacitances $C(M1, Vb_H)$, $C(M1, Vb_M)$ and $C(M1, Vb_L)$ completely identical, but, if the values of $Vb_H$, $Vb_M$ and $Vb_L$ are sufficiently close to one another, the input equivalent capacitances of respective modes can be equalized in first approximation.

In the case where the available choice of RF bands are comprised of four or more bands, fourth, fifth and any more required field effect transistors can be added to the pre-stage amplification unit, and connected to the load impedance Rd1, the degeneration inductance Ldg and the input impedance matching circuit MCK in the same manner as in the connection of the third field effect transistor.

[Fifth Embodiment]

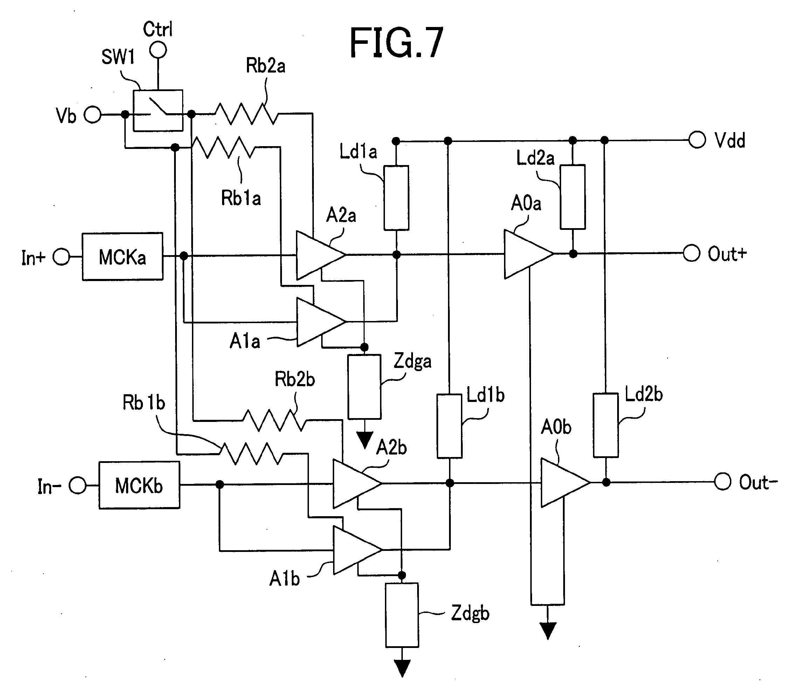

FIG. 7 shows the main part of a differential type multi-band LNA adaptable to two RF bands including a high band (HB) and a low band (LB), (hereinafter referred to as the multi-band differential LNA), as a fifth preferred embodiment of the invention. As was the case with the first embodiment, the circuit elements connected to the input and output sides of the multi-band differential LNA are not shown here for the sake of simplification of illustration.

In this embodiment, two LNAs (first and second LNAs) each of which has the same structure as the first embodiment (FIG. 1) are differentially connected. In the description of this embodiment, its circuit elements are denoted respectively by the same reference symbols in FIG. 1, and duplication of description with FIG. 1 is avoided by adding "a" to the end of the reference symbol of a constituent element of the first LNA and "b" to the end of the reference symbol of a constituent element of the second LNA.

Supply of the bias voltage Vb to the second fundamental amplifiers A2a and A2b in the first and second LNAs is controlled by the common control switch SW1. Differential input signals are supplied to the input signal line In+ of the first LNA and the input signal line In- of the second LNA, and differential signals are outputted to signal lines Out+ and Out- from the fundamental amplifiers signal amplifiersA0a and A0b constituting the respective post-stage amplification units. It is also conceivable to configure a differential amplifier by the fundamental amplifiers A0a and A0b so that a single-end output signal is supplied from a single signal line Out.

When the multi-band differential LNA of this embodiment is desired to operate in the HB mode, the second fundamental amplifiers A2a and A2b are turned off by supplying a control signal for opening the control switch SW1 to the terminal Ctrl. Then the effective input impedances of the first fundamental amplifiers A1a and A1b match matching circuits MCKa and MCKb, respectivey, and the multi-band differential LNA will have the desired HB characteristics.

When the multi-band differential LNA is desired to operate in the LB mode, the second fundamental amplifiers A2a and A2b are turned on by supplying a control signal for closing the control switch SW1 to the terminal Ctrl. Then the combined equivalent input impedances of the first and second fundamental amplifiers A1a and A2a, and the combined equivalent input impedances of the first and second fundamental amplifiers A1b and A2b, match the matching circuits MCKa and MCKb, respectively, and the multi-band differential LNA will have the desired LB characteristics.

[Sixth Embodiment]

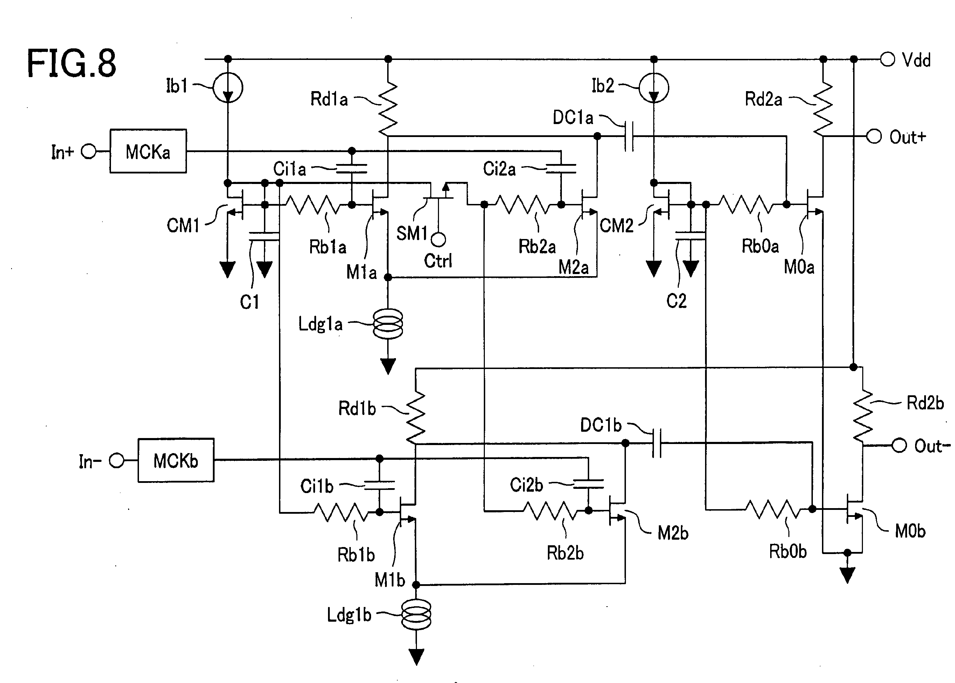

FIG. 8 shows the main part of a multi-band differential LNA adaptable to two RF bands including the high band (HB) and the low band (LB) as a sixth embodiment of the invention. As was the case with the first embodiment, the circuit elements connected to the input and output sides of the multi-band differential LNA are not shown here for the sake of simplification of illustration.

In this embodiment, two LNAs (first and second LNAs) each of which has the same structure as the second embodiment (FIG. 2) are differentially connected. In the description of this embodiment, its circuit elements are denoted respectively by the same reference symbols in FIG. 2, and duplication of description with FIG. 2 is avoided by adding "a" to the end of the reference symbol of a constituent element of the first LNA and "b" to the end of the reference symbol of a constituent element of the second LNA. Cila through Ci2b denote capacitances for separating DC potentials.

A bias voltage for turning on first field effect transistors M1a and M1b is supplied from a common current mirror circuit comprised of the field effect transistor CM1. The second field effect transistors M2a and M2b are selectively switched on by a common control switch comprising of the field effect transistor SM1. Similarly, a bias voltage for turning on the field effect transistors M0a and M0b of a post-stage amplification unit is also supplied from a common current mirror circuit comprised of the field effect transistor CM2 through bias resistors Rb0a and Rb0b, respectively.

Differential input signals are supplied to the input signal line In+ of the first LNA and the input signal line In- of the second LNA, and differential signals are outputted from the field effect transistors M0a and M0b of the post-stage to the output signal lines Out+ and Out-. A differential amplifier may be configured as well with the field effect transistors M0a and M0b instead.

When the multi-band differential LNA is desired to operate in the HB mode, the second field effect transistors M2a and M2b are turned off by supplying a control signal for opening the control switch SM1 to the terminal Ctrl. Then, as the effective input impedances of the first field effect transistors M1a and M1b match the respective matching circuits MCK1a and MCK1b, the multi-band differential LNA will have the desired HB characteristics.

When the multi-band differential LNA is desired to operate in the LB mode, the second field effect transistors M2a and M2b are turned on by supplying a control signal for closing the control switch SM1 to the terminal Ctrl. Then, as the combined equivalent input impedances of the first and second field effect transistors M1a and M1b connected in parallel match the matching circuit MCKIa and the combined equivalent input impedances of the first and second field effect transistor M1b and M2b connected in parallel match the matching circuit MCK1b, the multi-band differential LNA will have the desired LB characteristics. The conditions of multi-band matching of this embodiment are the same as those of the single-end type multi-band LNA shown in FIG. 2.

[Seventh Embodiment]

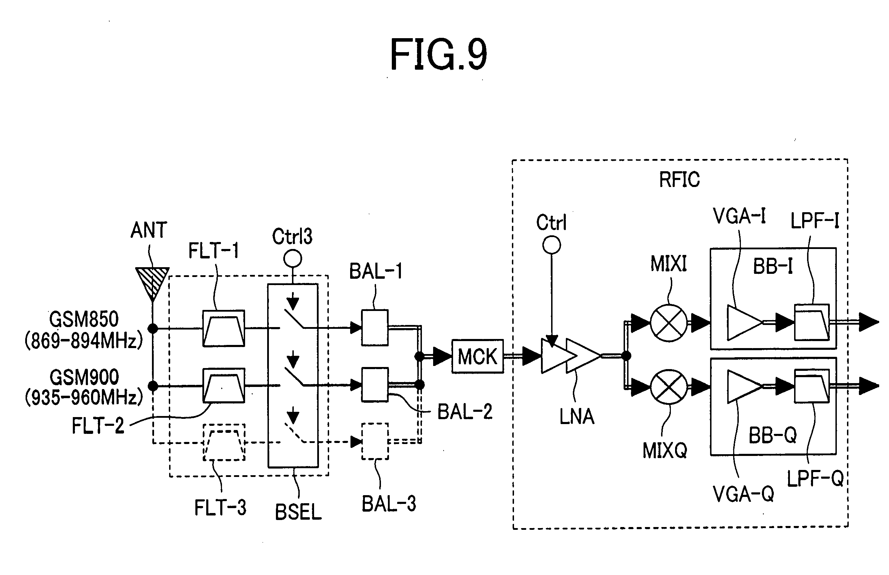

FIG. 9 shows one embodiment of QUAD band radio module for GSM use to which the multi-band LNAs shown in FIG. 1, FIG. 2, FIG. 7 and FIG. 8 are applied.

Radio signals transmitted from a base station are received by the antenna ANT and entered into the band pass filters FLT-1 and FLT-2, which correspond to GSM850 and GSM900, respectively, through the antenna switch (not shown). The band pass filters FLT-1 and FLT-2 suppress interference signals and noise outside the band, and selectively outputs signals on all the channels in each reception frequency band. The band pass filters FLT-1 and FLT-2 are connected to baluns BAL-1 and BAL-2 via a band selector switch array BSEL.

The band selector switch array BSEL selects a filter FLT-j (j = 1 or 2) according to a band selection signal supplied to a terminal Ctrl3, and transfers received signals of a specific frequency band outputted from the filter into a balun BAL-j. The balun BAL-j converts the received signals of the specific frequency band from single-end signals into differential signals. The output signals of the balun BAL-j are entered into the multi-band low noise amplifier LNA according to the invention via the input impedance matching circuit MCK, and signals amplified by the LNA are converted into baseband I/Q signals by I/Q mixers MIXI and MIXQ. A local frequency synthesizer for the frequency conversion is not shown here for the sake of simplification of illustration.

The output signals of MIXI and MIXQ are entered into an I signal baseband circuit BB-I and a Q signal baseband circuit BB-Q, respectively, which extract wanted signals and amplify the extracted signals to a desired intensity, and thereafter demodulated by circuits subsequent to the RF-IC of the post-stage configured on another chip. The band selection signal to be provided to the terminal Ctrl3 of BSEL and the switching control signal to be provided to the control terminal Ctrl of the LNA are generated by a band control unit (not shown).

If a third frequency band comes to be used in future GSM systems, in addition to GSM850 and GSM900 in current use, a band pass filter FLT-3 and a balun BAL-3 designed for the third GSM frequency band may be connected to the band selector switch array BSEL. In this case, an LNA having circuit configuration capable of switching among HB, MB and LB, as shown in FIG. 5 or FIG. 6, for instance, may be applied.

[Eighth Embodiment]

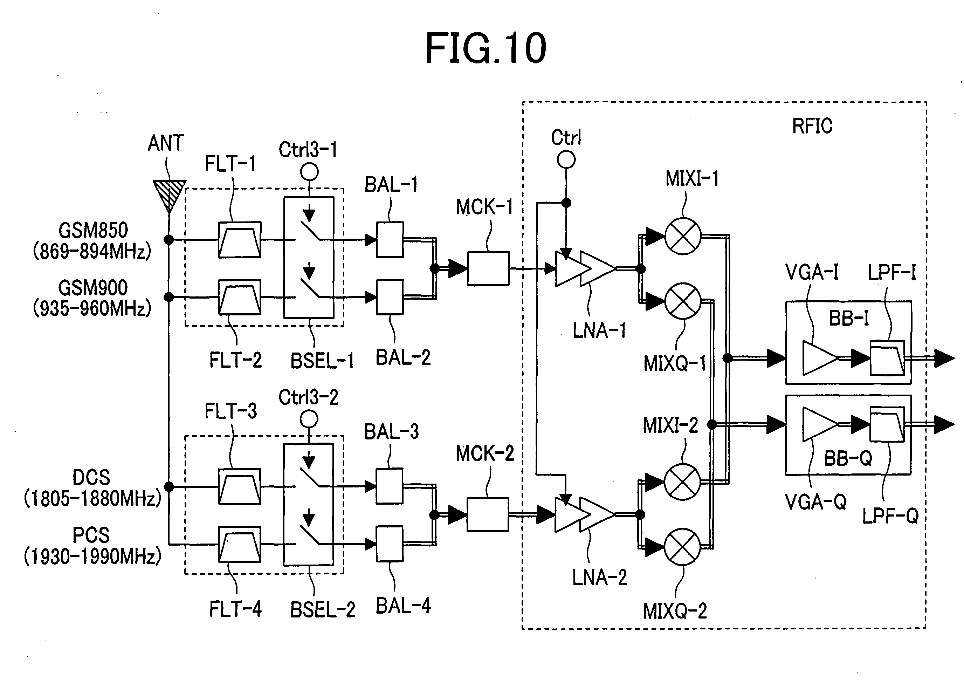

FIG. 10 shows one embodiment of QUAD band radiomodule adaptable to GSM850, GSM900, DCS or PCS, to which the multi-band LNAs shown in FIG. 1, FIG. 2, FIG. 7 and FIG. 8 are applied.

In this embodiment, a first multi-band amplifier LNA-1 permitting mode switching between GSM850 and GSM900 and a second multi-band amplifier LNA-2 permitting mode switching between DCS and PCS are prepared in the RF-IC unit. Signals amplified by the first multi-band amplifier LNA-1 are entered into an I signal baseband circuit BB-I and a Q signal baseband circuit BB-Q after converting them into baseband I/Q signals by I/Q mixers MIXI-1 and MIXQ-1. On the other hand, signals amplified by the second multi-band amplifier LNA-2 are entered into the I signal baseband circuit BB-I and the Q signal baseband circuit BB-Q after converting them into baseband I/Q signals by I/Q mixers MIXI-2 and MIXQ-2.

Radio signals transmitted from a base station are received by the antenna ANT, and entered into band pass filters FLT-1 through FLT-4 that correspond to GSM850, GSM900, DCS and PCS, respectively, through an antenna switch (not shown).

The band pass filters FLT-1 and FLT-2 are connected to the balun BAL-1 and BAL-2 via a band selector switch array BSEL-1. The band selector switch array BSEL-1 selects a filter FLT-j (j = 1 or 2) according to a band selection signal supplied to a terminal Ctrl3-1, and enters received signals of a specific frequency band outputted from the selected filter into a balun BAL-j. The balun BAL-j converts the received signals of the specific frequency band from single-end signals into differential signals. The output signals of the balun BAL-j are entered into the multi-band low noise amplifier LNA-1 via the input impedance matching circuit MCK-1. However, when the DCS or PCS band is selected, there is no output from the input impedance matching circuit MCK-1.

The band pass filters FLT-3 and FLT-4 are connected to baluns BAL-3 and BAL-4 via a band selector switch array BSEL-2. The band selector switch array BSEL-2 selects a filter FLT-k (k = 3 or 4) according to a band selection signal supplied to a terminal Ctrl3-2, and enters received signals of a specific frequency band outputted from the filter into a balun BAL-k.

The balun BAL-k converts the received signals of the specific frequency band from single-end signals into differential signals. The output signals of the balun BAL-k are entered into the multi-band amplifier LNA-2 via the input impedance matching circuit MCK-2. When the GSM850 or GSM900 band is selected, there is no output from the input impedance matching circuit MCK-2. The band control signal to be provided to BSEL-1 and BSEL-2 and the switching control signals to be provided to LNA-1 and LNA-2 are generated by a band control unit (not shown).

According to this embodiment, the number of LNAs to be provided in the RF-IC and the number of MCK circuits required as external elements for the RF-IC can be reduced in comparison with the conventional configuration shown in FIG. 13. Therefore, the number of external connection pins of the RF-IC can be smaller, and the RF-IC and the radio module can be reduced in size.

[Ninth Embodiment]

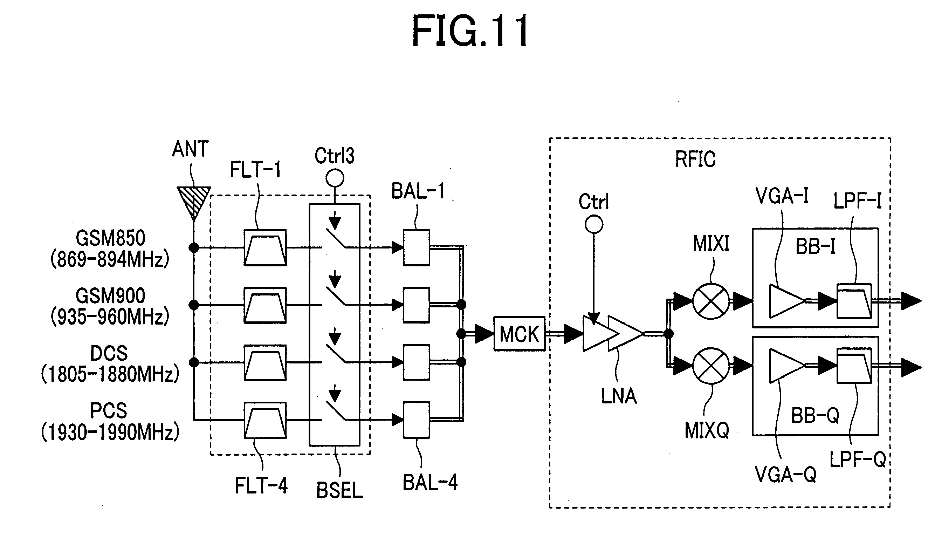

FIG. 11 shows another embodiment of QUAD band radio module to which the multi-band LNA according to the invention is applied. This embodiment represents the configuration of a QUAD band radio module in which receiving signals of GSM850, GSM900, DCS and PCS are amplified with a single LNA.

Radio signals transmitted from a base station are received by the antenna ANT, and entered into the band pass filters FLT-1 through FLT-4 prepared correspondingly to GSM850, GSM900, DCS and PCS, respectively through an antenna switch (not shown). The band pass filters FLT-1 through FLT-4 are connected to the baluns BAL-1 through BAL-4 via the band selector switch array BSEL.

The band selector switch array BSEL selects a filter according to a band selection signal supplied to the terminal Ctrl3, and enters received signals of a specific frequency band outputted from the selected filter FLT-j into the balun BAL-j. The balun BAL-j converts the received signals of the specific frequency band from single-end signals into differential signals. The output signals of the balun BAL-j are entered into the multi-band low noise amplifier LNA via the input impedance matching circuit MCK, and signals amplified by the LNA are converted into baseband I/Q signals by the I/Q mixers MIXI and MIXQ.

The output signals of MIXI and MIXQ are entered into the I signal baseband circuit BB-I and the Q signal baseband circuit BB-Q, respectively, which extract wanted signals and amplify the extracted signals to a desired intensity, and thereafter demodulated by circuits subsequent to the RF-IC of the post-stage configured on another chip. The band selection signal to be provided to the terminal CTrl3 of BSEL and the band selection control signal to be provided to the control terminal Ctrl of the LNA are generated by a band control unit (not shown). The LNA applicable to this embodiment can be applied to increase selectable frequency bands in the same way as the expansion of the first embodiment (FIG. 1) to the third embodiment (FIG. 5).

[Tenth Embodiment]

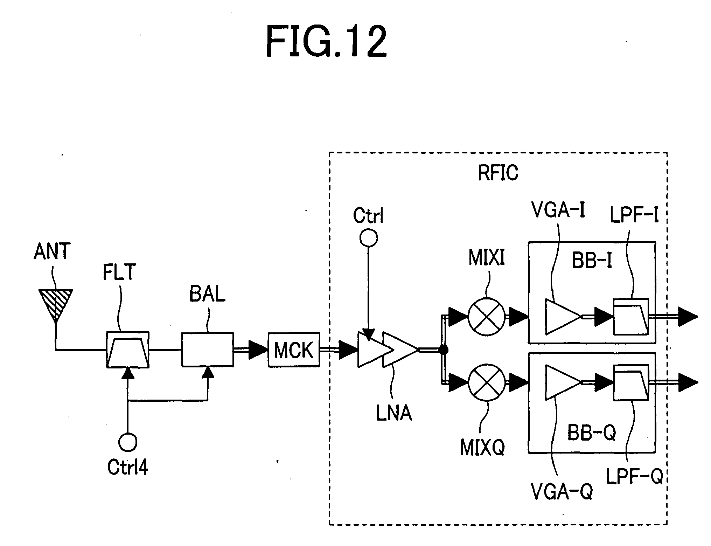

FIG. 12 shows still another embodiment of multi-band radio module to which multi-band LNA according to the invention is applied.

In this embodiment, a variable band pass filter FLT and a variable balun BAL whose operation band can be varied according to a band selection signal given to a terminal Ctrl4 are used in place of a plurality of band pass filters and a plurality of baluns, each having its own dedicated band, used in the configurations shown in FIG. 9 through FIG. 11.

Radio signals received by the antenna ANT are entered into the variable band pass filter FLT through an antenna switch (not shown) to suppress interference signals and noise outside a specific band designated by a band selection signal, and signals on all the channels of the specific receiving band are selectively outputted. The output signals of the filter FLT are converted from single-end signals into differential signals by the balun BAL tuned to the specific receiving band, and entered into the multi-band low noise amplifier LNA through the input impedance matching circuit MCK. A band selection signal is supplied to the control terminal Ctrl of the LNA in association with the switching-over of the band selection signal provided to the control terminal Ctrl4. The output signals of the LNA are entered into the I signal baseband circuit BB-I and the Q signal baseband circuit BB-Q after converting them into baseband I/Q signals by the I/Qmixers MIXI and MIXQ as described with reference to FIG. 9. The baseband circuits BB-I and BB-Q supply desired signals amplified to a desired intensity, to post-stage circuits configured on another chip.

[Other Embodiments]

At least one of the load resistors Rd1 and Rd2 in the multi-band LNAs of the second and fourth embodiments described above may be replaced with an inductor or a serial circuit of an inductor and a resistor. Similarly, at least one pair out of the load impedance pair comprising the load resistors Rd1a and Rd1b and the load impedance pair comprising the load resistors Rd2a and Rd2b in the multi-band differential LNA of the sixth embodiment may be replaced with an inductor or a serial circuit of an inductor and a resistor, on condition that the impedances of each pair be identical.

The multi-band LNA technology according to the invention is applicable to cases where an RF-IC and a wireless radio frequency module for mobile phone terminals of the CDMA 2000 type are to be adapted to a plurality of RF bands. The multi-band LNA technology according to the invention is also applicable, for instance, to RF-ICs for use in the 2.4GHz band and the 5.2GHz band or radio frequency modules in a wireless apparatus conforming to the IEEE 802.11a/b/g Protocol for wireless LANs.

According to the embodiments of the invention so far described, wireless semiconductor integrated circuits can be reduced in size because a plurality of RFbands can share a single low noise amplifier. Furthermore, since a plurality of RFbands can share an input impedance matching circuit, a multi-band RF module can be reduced in size. A tentative calculation using a GSM type QUAD band system has shown that the area size of RF-IC chip can be reduced by 10% to 15%, and the module area including external elements, by 15% to 30%.

Therefore, the present invention provides highly suitable LNAs for multi-band terminals compatible with multi-band mobile phones, wireless LANs and other wireless systems.

**Claims**

1. A multi-band low noise amplifier, comprising:

   a pre-stage amplification unit including a plurality of fundamental amplifiers connected to one another in parallel, said fundamental amplifiers sharing a load impedance connected to a source voltage and a grounded degeneration impedance and having input signal lines commonly connected to an input impedance matching circuit; and
   a post-stage amplifier to which the output signals of said plurality of fundamental amplifiers are commonly inputted,

   wherein the input impedance of said pre-stage amplification unit is selectively optimized for a plurality of RF bands according to the ways for supplying bias voltages to said plurality of fundamental amplifiers.

2. The multi-band low noise amplifier according to claim 1, wherein said pre-stage amplification unit includes:

   first and second fundamental amplifiers; and
   a pre-stage bias control unit for supplying a bias voltage to said first fundamental amplifier through a first bias resistor and to said second fundamental amplifier through a serial circuit of a control switch and a second bias resistor, and

wherein the input impedance of said pre-stage amplification unit is optimized for a first RF band by said first fundamental amplifier and degeneration impedance when said control switch is off, and optimized for a second RF band lower in frequency than said first RF band by said first and second fundamental amplifiers and degeneration impedance when said control switch is on.

**3.** The multi-band low noise amplifier according to claim 1,
wherein said pre-stage amplification unit includes:

N (N is an integer of more than 2) fundamental amplifiers; and
a pre-stage bias control unit for supplying a bias voltage to each of the fundamental amplifiers through an individual bias resistor,

wherein said pre-stage bias control unit includes (N-1) control switches each connected in series to each of the bias resistors so that a bias voltage is constantly supplied to the first fundamental amplifier and selectively to each of the second through N-th fundamental amplifiers, and
wherein the input impedance of said pre-stage amplification unit is optimized for a first RF band by said first fundamental amplifier and degeneration impedance when all of said control switches are off, and optimized for another RF band lower in frequency than said first RF band by said first fundamental amplifier, said degeneration impedance and at least one of the other fundamental amplifiers that is made operational by the supply of a bias voltage when the corresponding one or more of said control switches are on.

**4.** The multi-band low noise amplifier according to claim 3,
wherein the number of fundamental amplifiers to operate in parallel in said pre-stage amplification unit is varied by turning on said control switch depending on the RF band to be received.

**5.** A multi-band low noise amplifier module, comprising:

a first low noise amplifier connected to a first input impedance matching circuit for positive input signals; and
a second low noise amplifier connected to a second input impedance matching circuit for negative input signals,

wherein each of said first and second low noise amplifiers includes a multi-band low noise amplifier comprising:

a pre-stage amplification unit including a plurality of fundamental amplifiers connected to one another in parallel, said fundamental amplifiers sharing a load impedance connected to a source voltage and a grounded degeneration impedance and having input signal lines commonly connected to an input impedance matching circuit; and
a post-stage amplifier to which the output signals of said plurality of fundamental amplifiers are commonly inputted,

wherein the input impedance of said pre-stage amplification unit is selectively optimized for a plurality of RF bands according to the ways for supplying a bias voltage to said plurality of fundamental amplifiers, and
wherein said first and second low noise amplifiers output differentially amplified signals relative to differential input signals supplied from said first and second input impedance matching circuits.

**6.** The multi-band low noise amplifier module according to claim 5,
wherein each of said pre-stage amplification units includes:

first and second fundamental amplifiers; and
a pre-stage bias control unit for supplying a bias voltage to said first fundamental amplifier through a first bias resistor and to said second fundamental amplifier through a serial circuit of a control switch and a second bias resistor, and

wherein the input impedance of said pre-stage amplification unit is optimized for a first RF band by said first fundamental amplifier and degeneration impedance when said control switch is off, and optimized for a second RF band lower in frequency than said first RF band by said first and second fundamental amplifiers and degeneration impedance when said control switch is on.

7. The multi-band low noise amplifier module according to claim 6,
wherein said pre-stage bias control units of said first and second low noise amplifiers share a control switch connected to mutually corresponding bias resistors.

8. The multi-band low noise amplifier module according to claim 5,
wherein each of said pre-stage amplification units includes:

N (N is an integer of more than 2) fundamental amplifiers; and
a pre-stage bias control unit for supplying a bias voltage to each of the fundamental amplifiers through an individual bias resistor,

wherein said pre-stage bias control unit includes (N-1) control switches each connected in series to each of the bias resistors so that a bias voltage is constantly supplied to the first fundamental amplifier and selectively to each of the second through N-th fundamental amplifiers, and
wherein the input impedance of said pre-stage amplification unit is optimized for a first RF band by said first fundamental amplifier and degeneration impedance when all of said control switches are off, and optimized for another RF band lower than said first RF band by said first fundamental amplifier, said degeneration impedance and at least one of the other fundamental amplifiers that is made operational by the supply of a bias voltage when the corresponding one or more of said control switches are on.

9. The multi-band low noise amplifier module according to claim 8,
wherein said pre-stage bias control units of said first and second low noise amplifiers share a control switch connected to mutually corresponding bias resistors.

10. The multi-band low noise amplifier according to claim 1,
wherein each of said fundamental amplifiers of said pre-stage amplification unit and said post-stage amplifier is formed of a field effect transistor, and said degeneration impedance includes an inductor element.

11. The multi-band low noise amplifier according to claim 10,
wherein said control switch includes a field effect transistor switch.

12. The multi-band low noise amplifier according to claim 10,
wherein each of the field effect transistors constituting the fundamental amplifiers of said pre-stage amplification unit has a gate width such that the input equivalent capacitance of the plurality of field effect transistors operating in parallel matches RF band to be received.

13. A wireless semiconductor integrated circuit, comprising:

a low noise amplifier;
an I signal mixer and a Q signal mixer for converting an output signal of said low noise amplifier into baseband I and Q signals;
an I signal baseband circuit connected to said I signal mixer; and
a Q signal baseband circuit connected to said Q signal mixer,

wherein said low noise amplifier comprises:

a pre-stage amplification unit including a first load impedance connected to a source voltage, a grounded degeneration impedance, and first and second fundamental amplifiers sharing an input signal lines and connected in parallel to each other;
a post-stage amplifier to which output signals of said first and second fundamental amplifiers are commonly inputted; and
a pre-stage bias control unit for supplying a bias voltage to said first fundamental amplifier through a first bias resistor and to said second fundamental amplifier through a serial circuit of a control switch and a second bias resistor, and

wherein the input impedance of said low noise amplifier is matched with a plurality of different RFbands by turning said control switch on or off.

**14.** The wireless semiconductor integrated circuit according to claim 13,
wherein said low noise amplifier constitutes a differential amplifier together with a second low noise amplifier having the same configuration, and
wherein said I signal mixer and Q signal mixer convert the output signals of said differential amplifier into baseband I and Q signals.

**15.** The wireless semiconductor integrated circuit according to claim 14,
wherein variations of the input impedance of said low noise amplifier are kept within the permissible range in all of said RF bands.

**16.** A multi-band RF module, comprising:

a front end circuit for selecting RF bands to be received; and
a semiconductor integrated circuit for RF use, for converting received signals of the RF band selected by the front end circuit into baseband signals,

wherein said semiconductor integrated circuit for RF use includes a multi-band low noise amplifier for receiving multi-band signals, whose band is selectable by said front end circuit, through an input impedance matching circuit.

**17.** The multi-band RF module according to claim 16,
wherein said front end circuit comprises:

a plurality of bandpass filters each for selecting a frequency band to be received;
a plurality of balun circuits, adapted for a different frequency band, for converting single-end signals into differential signals;
a band selector switch connected between said bandpass filters and balun circuits, and
an input impedance matching circuit connected to said plurality of balun circuits.

**18.** The multi-band RF module according to claim 16,
wherein said front end circuit comprises:

a variable band pass filter for selecting frequency band to be received;
a variable balun circuit connected to said variable band pass filter, for converting single-end signals in to differential signals; and
an input impedance matching circuit connected to said balun circuit.

# FIG.1

# FIG.2

EP 1 693 957 A1

# FIG.3A

## SINGLE BAND LNA CHARACTERISTICS

### INDEPENDENT (LOW BAND)

# FIG.3B

## MULTI-BAND LNA CHARACTERISTICS

### SWITCH (LOW BAND)

EP 1 693 957 A1

# FIG.4A

## SINGLE BAND LNA CHARACTERISTICS

### INDEPENDENT (HIGH BAND)

# FIG.4B

## MULTI-BAND LNA CHARACTERISTICS

### SWITCH (HIGH BAND)

EP 1 693 957 A1

# FIG.5

EP 1 693 957 A1

# FIG.6

# FIG.7

EP 1 693 957 A1

# FIG.8

EP 1 693 957 A1

# FIG.9

EP 1 693 957 A1

# FIG.10

EP 1 693 957 A1

FIG.11

# FIG.12

EP 1 693 957 A1

# FIG.13

PRIOR ART

## FIG.14
PRIOR ART

# FIG.15
## PRIOR ART

# FIG.16
## PRIOR ART

AMPLIFICATION
BLOCK

**European Patent Office**

**EUROPEAN SEARCH REPORT**

Application Number

EP 06 25 0380

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | VIDOJKOVIC V ET AL: "Fully-integrated DECT/Bluetooth multi-band LNA in 0.18 /spl mu/m CMOS" CIRCUITS AND SYSTEMS, 2004. ISCAS '04. PROCEEDINGS OF THE 2004 INTERNATIONAL SYMPOSIUM ON VANCOUVER, BC, CANADA 23-26 MAY 2004, PISCATAWAY, NJ, USA,IEEE, US, 23 May 2004 (2004-05-23), pages I-565, XP010719178 ISBN: 0-7803-8251-X *I. Introduction* *II. Design of the multi-band LNA* *Figure 1* | 1-18 | INV. H03F3/19 |
| A | YO-SHENG LIN ET AL: "A miniaturized monolithic low noise amplifier for 2.4/5.2/5.7 GHz WLAN applications using InGaP/GaAs HBT technology" ADVANCED SYSTEM INTEGRATED CIRCUITS 2004. PROCEEDINGS OF 2004 IEEE ASIA-PACIFIC CONFERENCE ON FUKUOKA, JAPAN 4-5 AUG. 2004, PISCATAWAY, NJ, USA,IEEE, US, 4 August 2004 (2004-08-04), pages 292-295, XP010733940 ISBN: 0-7803-8637-X *5. MULTI-BAND LNA* *FIGURE 3* | 1-18 | |
| A | CHUN-LIN KO ET AL: "A CMOS dual-mode RF front-end receiver for GSM and WCDMA" ADVANCED SYSTEM INTEGRATED CIRCUITS 2004. PROCEEDINGS OF 2004 IEEE ASIA-PACIFIC CONFERENCE ON FUKUOKA, JAPAN 4-5 AUG. 2004, PISCATAWAY, NJ, USA,IEEE, US, 4 August 2004 (2004-08-04), pages 374-377, XP010733956 ISBN: 0-7803-8637-X * the whole document * | 1-18 | TECHNICAL FIELDS SEARCHED (IPC) H03F H03H |

The present search report has been drawn up for all claims

| Place of search | Date of completion of the search | Examiner |
|---|---|---|
| The Hague | 11 April 2006 | Aouichi, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)